# EUROPEAN PATENT SPECIFICATION

(11) **EP 2 204 837 B1**
(45) Date of publication and mention of the grant of the patent: **18.05.2011**
(21) Application number: 09179403.2
(22) Date of filing: 16.12.2009
(51) Int. Cl.: H01J 17/49

(54) **Method of manufacturing an electromagnetic interference (EMI) shielding filter for a plasma display panel and an EMI shielding filter for a plasma display panel using the same**
Verfahren zur Herstellung eines Schutzfilters gegen elektromagnetische Interferenzen (EMI) für Plasmaanzeigetafel und EMI-Schutzfilter für Plasmaanzeigetafel damit
Procédé de fabrication d'un filtre de protection contre l'interférence électromagnétique pour un écran d'affichage à plasma et filtre de protection contre l'interférence électromagnétique pour un écran d'affichage à plasma l'utilisant

(30) Priority: 31.12.2008 US 142057 P; 03.12.2009 US 630832
(43) Date of publication of application: 07.07.2010
(73) Proprietor: Samsung SDI Co., Ltd., Gyeonggi-do (KR)
(72) Inventor: Lim, Jaeseok, Gyeonggi-do (KR); Jin, Sangyoung, Gyeonggi-do (KR); Kim, Minhyung, Gyeonggi-do (KR); Yoon, Heeyoul, Gyeonggi-do (KR); Ju, Ria, Gyeonggi-do (KR); Pyo, Younghak, Gyeonggi-do (KR); Paek, Seunghyuck, Gyeonggi-do (KR); Seo, Sangchul, Gyeonggi-do (KR)
(74) Representative: Hengelhaupt, Jürgen

(56) References cited:
- EP-A2- 1 109 434
- JP-A- 2003 297 567
- JP-A- 2007 294 355
- JP-A- 2008 000 733
- US-A1- 2007 128 855

## Description

### BACKGROUND OF THE INVENTION

### 1. Field of the Invention

An aspect of the present invention relates to a method of manufacturing an electromagnetic interference (EMI) shielding filter for a plasma display panel and an plasma display panel using the same.

### 2. Description of the Related Art

A plasma display device often indudes a plasma display panel having a discharge cell defined by an address electrode, a scan electrode and a sustain electrode, and phosphors being applied to the discharge cell; and a drive unit for driving the plasma display panel. The plasma display device displays images through the generation of visible rays in response to excitation of phosphors by the action of ultraviolet rays generated upon gas discharge.

Plasma display devices often suffer from high-level generation of electromagnetic waves in the plasma display panel during a driving process thereof. For this reason, a plasma display device may be fabricated with a separate electromagnetic interference (EMI) shielding filter for blocking electromagnetic waves to the front or display side of the plasma display panel.

Alternatively, the EMI shielding filter is fabricated by the formation of a transparent conductive layer on a separate base such as film or glass substrate. However, such a transparent conductive layer and separate base such as film or glass substrate increase production costs of plasma display devices.
An example of a method of manufacturing an EMI shielding filter for a plasma display panel can be found in JP 2007 294355.

### SUMMARY OF THE INVENTION

Aspects of the present invention provide a method of manufacturing an electromagnetic interference (EMI) shielding filter for a plasma display panel and an EMI shielding filter for plasma display panel using the same which are capable of simplifying production processes and reducing production costs in conjunction with the size reduction of a plasma display device induding the plasma display panel through the formation of an EMI shielding filter including a hydrophobic layer and a conductive mesh pattern directly on a plasma display panel by means of an ink-jet method using conductive ink.

Accordingly, a method of manufacturing a plasma display panel is provided in claim 1.

In the method, way the electromagnetic wave shield filter is formed directly on the image-displaying surface of the plasma display panel. The production process is simplified and the production costs are minimized since a separate base for the electromagnetic wave shield filter can be avoided.

The coating solution may be applied to the entirety of the second surface of the first panel. Preferably, the coating solution is applied by printing or spin coating.

The coating solution may comprise fiuoroalkylsilane FAS. Preferably, the coating solution comprises fluoroalkylsilane FAS in a concentration between 0.05M and 0.3M. The concentration advantageously provides a sufficient hydrophic effect. Fluoroalkylsilane is a mixture of trichloro(3,3,3-trifluoropropyl)silane and trichloro(1H,1H,2H,2H-perfiuorooctyl)silane. The coating solution can further comprise 3-aminopropyl triethoxy silane and/or 3-mercaptopropyl triethoxy silane. The ratio of volumes of the mixtures of trichloro(3,3,3-trifluoropropyl)silane and trichloro(1H,1H,2H,2H perfluorooctyl)silane lies preferably between 100:1 to 20:1. The preferred ration of the volumes of mixtures also provides a desired hydrophobic effect.

The conductive ink is applied by ink-jet printing to form a conductive mesh pattern of individual ink drops connected to one another forming conductive lines. The individual ink drops preferably has a volume of 3pL to 30pL. The conductive ink may be a silver nano ink and/or the conductive ink includes trace amounts of organic dispersant and inorganic frit. The silver nano ink may be a dispersion of silver nano-particles having a particle diameter of 5nm to 100nm in n-tetradecane. The content of the silver nano-partilcles lies preferably in the range of 50wt% to 90wt% in the conductive ink.

The heating step may include heating the conductive mesh pattern and the hydrophobic layer to a temperature at which organic materials are removed from the conductive mesh pattern. The heating step preferably indudes heating to temperatures between 250°C and 400°C.

The conductive mesh pattern preferably has a line width of 30 to 70 µm. The mesh surface resistance preferably is 0.05 to 0.4 Ω/ (i.e. per square). In a preferred embodiment, the conductive mesh pattern forms a tetragonal pattern of a plurality of conductive lines with a pitch of between 200µm and 400µm. The conductive mesh pattern may also be formed of a plurality of conductive lines with a line width of repeated thick and thin portions with an average ratio of the thickest portion to the thinnest portion of each of the plurality of conductive lines between 1.0:0.6 and 1.0:0.9.

The conductive mesh pattern may be formed directly on an outside surface of the front glass of the plasma display panel and/or the conductive mesh pattern may be formed as the last step of the fabrication of the plasma display panel.

It is further provided a plasma display panel according to claim 14.

The conductive mesh pattern may have a line width of 30 to 70 µm. The conductive mesh pattern may have a mesh surface resistance of 0.05 to 0.4 Ω/ (i.e. per square). The conductive mesh pattern may form a tetragonal pattern of a plurality of conductive lines with a pitch of between 200µm and 400µm. The conductive mesh pattern formed of individual connected ink drops form of a plurality of conductive lines with a line width of repeated thick and thin portions. The conductive mesh pattern may be formed of a plurality of conductive lines with a line width of repeated thick and thin portions with an average ratio of the thickest portion to the thinnest portion of each of the plurality of conductive lines between 1.0:0.6 and 1.0:0.9.

The hydrophobic layer may comprise fiuoroalkylsilane. The conductive mesh pattern may comprise or may consist of silver nano particles.

### BRIEF DESCRIPTION OF THE DRAWINGS

FIG. 1 is a flow chart illustrating a method of manufacturing an electromagnetic interference (EMI) shielding filter for a plasma display panel in accordance with one embodiment of the present invention; and

FIG. 2a is a perspective view of an embodiment of a panel of the present invention before the EMI shielding filter has been applied to the panel.

FIG. 2b is a perspective view of the panel of FIG. 1 after a hydrophobic layer or surface treatment has been applied to the panel.

FIG. 2c is a perspective view of a conductive ink being applied to the panel of FIG. 1.

FIG. 2d is a perspective of the panel of FIG. 1 coated with the conductive ink being heated.

### DETAILED DESCRIPTION

In the following detailed description, only certain exemplary embodiments of the present invention are shown and described, by way of illustration. As those skilled in the art would recognize, the invention may be embodied in many different forms and should not be construed as being limited to the embodiments set forth herein. Like reference numerals designate like elements throughout the specification.

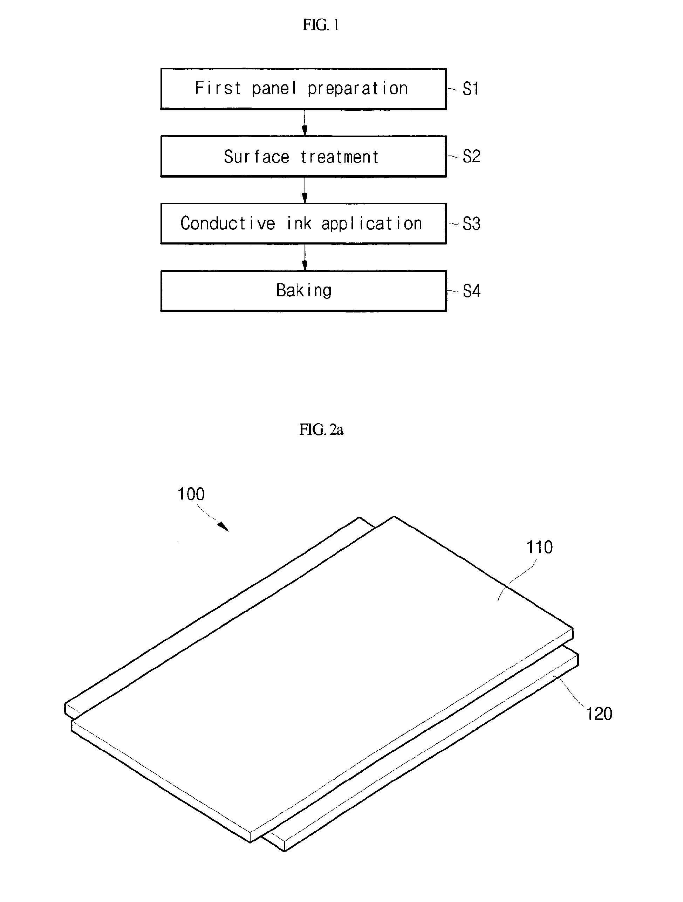

FIG. 1 is a flow chart illustrating a method of manufacturing an electromagnetic interference (EMI) shielding filter (i.e., an electromagnetic wave shield) for a plasma display panel in accordance with one embodiment of the present invention, and FIGS. 2a through 2d are perspective views illustrating a method of manufacturing an electromagnetic interference (EMI) shielding filter for a plasma display panel in accordance with one embodiment of the present invention.

Referring to FIG. 1, the method of manufacturing the plasma display device in accordance with one embodiment of the present invention indudes a first panel preparation step (S1), a surface treatment step (S2), a conductive ink application step (S3) and a baking step (S4).

First, referring to FIG. 2a, the first panel preparation step (S1) is a step of preparing a first panel 110.

The first panel 110 displays images and includes display electrodes to apply a voltage necessary for gas discharge of the plasma display device, and a dielectric layer formed on a first surface, the first surface facing a second panel 120 and being opposite to an image-displaying or second surface of the first panel 110. Although the panel 100 is shown in FIG. 1 as a combined form of the first panel 110 with the second panel 120, the first panel 110 alone may be prepared without being combined with the second panel 120.

The second panel 120 includes address electrodes (not shown) adapted to apply a voltage necessary for gas discharge of the plasma display device and formed on a surface facing the first panel 110. The second panel 120 may further include an isolation wall, phosphors, a dielectric, and a protection film provided on the surface where the address electrodes were formed.

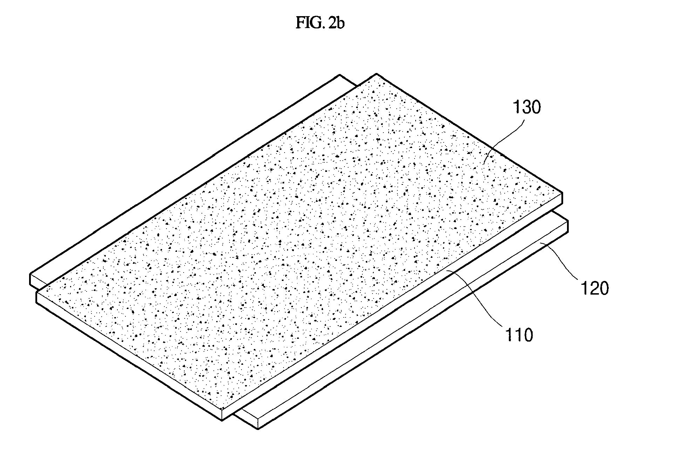

Referring now to FIG. 2b, the surface treatment step (S2) is a step of forming a hydrophobic layer 130 by applying a coating solution to the entirety of a second surface of the first panel 110, that is, the surface not facing to the second panel 120.

The surface treatment step (S2) may employ fluoroalkylsilane (FAS) as a coating solution. The fluoroalkylsilane is applied to the entire surface of the first panel 110 by a conventional method, e.g. printing or spin coating. In one embodiment, the fluoroalkylsilane is a mixture of trichloro(3,3,3-trifluoropropyl)silane and trichloro(1H,1H,2H,2H-perfluorooctyl)silane. In one embodiment, the ratio of volumes of the mixture of trichloro(3,3,3-trifluoropropyl)silane and trichloro(1H,1H,2H,2H-perfluorooctyl)silane is between about 100:1 to about 20:1, and in one embodiment may be about 60:1. If the ratio of the volumes is greater than 100:1, a hydrophobic effect of the FAS may be insufficient and if the ratio is less than 20:1, the hydrophobic effect of the FAS may be excessive. However, it will be appreciated that if a different type of conductive ink is used for the EMI shielding filter, as described in more detail below, the volume ratios of the mixture may be different.

In one embodiment, the concentration of FAS is between about 0.05M and about 0.3M in n-octane, and in one embodiment, the concentration may be about 0.1 M. If the concentration is less than about 0.05M, a hydrophobic effect of the FAS may be insufficient and if the concentration is greater than about 0.3M, excess FAS may be used.

The hydrophobic layer 130 formed of FAS serves to control running and spreading of conductive ink on the surface of the first panel 110 to prevent excessive running and spreading which may occur upon application of the conductive ink in the subsequent conductive ink application step(S3).

When the hydrophobic layer 130 is formed of fluoroalkylsilane induding only trichloro(3,3,3-trifluoropropyl)silane without trichloro(1H,1H,2H,2H-perfluorooctyl)silane, spreadability of the conductive ink on the hydrophobic layer 130 is increased upon application of the conductive ink in the subsequent conductive ink application step (S3). As a result, it is difficult to form a conductive mesh pattern having a fine line-width of less than 100 µm on the hydrophobic layer 130. On the other hand, when the hydrophobic layer 130 is formed of the fluoroalkylsilane induding only of trichloro(1H,1H,2H,2H-perfluorooctyl)silane without trichloro(3,3,3-trifluoropropyl)silane, water repellency of the conductive ink on the hydrophobic layer 130 becomes excessively strong upon application of the conductive ink in the subsequent conductive ink application step (S3). As a consequence, when the formation of a line on the hydrophobic layer 130 is desired by connecting a plurality of ink drops, it is difficult to produce a complete line of connected ink drops.

In alternate embodiments, the FAS may be mixed with another compound such as 3-aminopropyl triethoxy silane and/or 3-mercaptopropyl triethoxy silane to be used as a surface treatment agent.

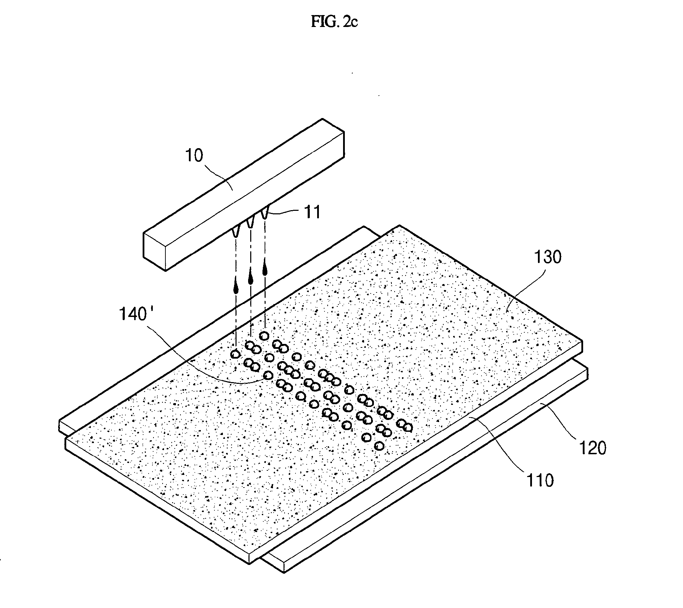

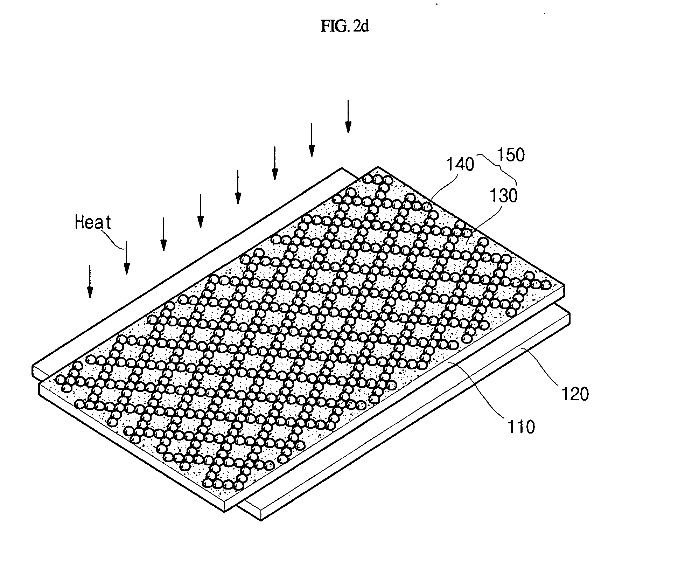

Referring to FIG. 2c, the conductive ink application step (S3) is a step of forming a conductive mesh pattern (140 of FIG. 2d) by applying the conductive ink to the hydrophobic layer 130.

The conductive ink application step (S3) may employ a silver nano ink as a conductive ink. The silver nano-ink may be a dispersion of silver nano-particles having a particle diameter of about 5 nm to about 100 nm in n-tetadecane. If a particle diameter of the silver nano-particles is less than about 5 nm, this may result in non-uniform dispersion of the silver nano-particles. On the other hand, if a particle diameter of the silver nano-particles is larger than about 100 nm, this may result in plugging of flow paths of the silver nano-ink in a plurality of nozzles 11 of an ink-jet applicator 10. As will be appreciated, the conductive ink does not have to be a silver nano-ink, but rather may be other types of conductive ink including other materials such as copper.

A content of the silver nano-particles may be in the range of about 50wt% to about 90wt% in the silver nano-ink, and the silver nano-ink may further include trace amounts of organic dispersant and inorganic frit in order to improve dispersibility and viscosity thereof. If a content of the silver nano-particles is less than about 50wt% of the silver nano-ink, this may lead to deterioration of electrical properties of the silver nano-ink. On the other hand, if a content of the silver nano-particles is greater than about 90wt% of the silver nano-ink, a content of the organic dispersant and inorganic frit in the silver nano-ink is decreased to thereby result in less improvement of the dispersibility and viscosity of the silver nano-ink.

The conductive ink application step (S3) includes application of the silver nano-ink to the hydrophobic layer 130 in an ink-jet manner using the ink-jet applicator 10, thus forming a conductive mesh pattern 140 where individual ink drops 140' are connected to one another. The conductive mesh pattern 140 has a line width with repeated thick and thin portions due to intrinsic nature of ink jet application. A thickness variation of a line formed by conductive ink drops can be controlled by varying the distance between each ink drop. In one embodiment, an average ratio of thickest portion of the line to the thinnest portion of the line is between about 1.0:0.6 and about 1.0:0.9, and in one embodiment the ratio is 1.0:0.7. If the distance between each ink drop is too large, the sheet resistance may increase thereby degrading the shield performance. If the distance is too small, too much ink may be used to form the line.

The conductive mesh pattern 140 is electrically connected to a ground of the plasma display device such that electromagnetic waves coming from the plasma display panel 100 are grounded to the ground of the plasma display device, thus shielding electromagnetic wave interference. For the further understanding, FIG. 2c shows the state prior to complete formation of the conductive mesh patern 140 on the hydrophobic layer 130, with the size of the ink drops 140' of the conductive mesh pattern 140 being exaggerated for darity, whereas FIG. 2d shows complete formation of the conductive mesh pattern 140.

In one embodiment, the conductive mesh pattern 140 in the present application is formed on an outside surface of the first panel 110 of the panel 100. It is desirable in one embodiment to have the conductive mesh pattern 140 formed after fabrication of the panel 100 because as the first panel 110 and second panel 120 are moved through the production line, the conductive mesh pattern 140 can be damaged if formed prior to the fabrication of the panel 100. In other embodiments, the conductive mesh pattern 140 can be formed on the first panel 110 prior to the fabrication of the panel 100.

Further, the conductive ink application step S3 can apply the conductive ink to design and form a tetragonal conductive mesh pattern (FIG. 2d) having a pitch of about 200 µm to about 400 µm. As used herein, "pitch" refers to the distance between two adjacent parallel lines that form the conductive mesh pattern. If a pitch of the conductive mesh pattern 140 is less than about 200 µm, a pitch of the conductive mesh pattern 140 becomes excessively dense to thereby lower light transmittance of the plasma display panel 100. On the other hand, if a pitch of the conductive mesh pattern 140 is higher than about 400 µm, an area of the conductive mesh pattern 140 occupied in the plasma display panel 100 is decreased to result in poor electromagnetic interference shielding efficiency of the plasma display panel 100.

In one embodiment, the conductive ink application step (S3) is performed in a manner that individual ink drops 140' being sprayed through multiple nozzles 11 of the ink-jet applicator 10 have a volume of about 3 pL to about 30 pL. If a volume of the individual ink drops 140' is less than about 3 pL, a line width of the conductive mesh pattern 140 is excessively thin to lower electrical conductivity in the plasma display panel 100. On the other hand, if a volume of the individual ink drops 140' is higher than about 30 pL, a line width of the conductive mesh pattern 140 is excessively thick to lower optical transmittance in the plasma display panel 100. In another embodiment, 12 pL is the upper limit for an ink drop volume. In still another embodiment, different sized ink drops may be used.

Table 1, below, illustrates various droplet volumes and the corresponding line widths and mesh surface resistances produced for each volume, wherein the pitch of the conductive mesh pattern is about 300 µm.

**Table 1**

| Droplet volume (pL) | Line width (µm) | Mesh surface resistance (Ω/square) |
|---|---|---|
| 3 | 32 | 0.4 |
| 4 | 34 | 0.33 |
| 8 | 40 | 0.20 |
| 20 | 60 | 0.11 |
| 30 | 70 | 0.05 |

As shown in Table 1, droplet volumes ranging from about 3 pL to about 30 pL produce line widths from between about 32 µm to about 70 µm and mesh surface resistances down to about 0.05 Ω/square.

Referring to FIG. 2d, the baking step (S4) is a step of thermally baking the conductive mesh pattern 140 to be fixed on the hydrophobic layer 130.

Specifically, the baking step (S4) indudes fixation of the conductive mesh pattern 140 to the hydrophobic layer 130 by removing organic materials contained in the conductive mesh pattern 140 using heat of between about 250°C to about 400°C. In one embodiment, hot air may be used to bake the conductive mesh pattern 140. Once the conductive mesh pattern 140 has been heated to a suitable temperature, the silver nano-particles no longer exist in particle form, but the pattern remains as a conductive mesh pattern formed from silver.

If a baking temperature of the conductive mesh pattern 140 is lower than about 250°C, the organic materials are not thoroughly removed from the conductive mesh pattern 140, thus resulting in deterioration of the electrical conductivity. On the other hand, if a baking temperature of the conductive mesh pattern 140 is higher than about 400°C, this may cause damage to the plasma display panel 100.

In this manner, the EMI shielding filter 150 including the hydrophobic layer 130 and the conductive mesh pattern 140 can have a line width of the conductive mesh pattern 140 of about 40 µm, light transmittance of about 77%, sheet resistance of about 0.2Ω/square, and a pencil hardness of about 6H in response to a pencil hardness test. Where it is applied to a plasma display device, the EMI shielding filter 150 meets the FCC EMI Class B.

As described above, the method of manufacturing an EMI shielding filter for a plasma display panel in accordance with one embodiment of the present invention can form an EMI shielding filter 150 including the hydrophobic layer 130 and the conductive mesh pattern 140 directly on the plasma display panel 100 by means of an ink-jet method using conductive ink.

Therefore, the method of manufacturing an EMI shielding filter for a plasma display panel in accordance with one embodiment of the present invention is capable of simplifying production processes and reducing production costs of a separate and additional base, as compared to fabrication of an EMI shielding filter through the formation of a conductive mesh pattern on a separate base by means of an etching process.

Further, the method of manufacturing an EMI shielding filter for a plasma display panel in accordance with one embodiment of the present invention is capable of saving production costs of a separate base and an expensive transparent conductive layer, as compared to fabrication of an EMI shielding filter through the formation of an expensive transparent conductive layer on a separate base.

Further, the method of manufacturing an EMI shielding filter for a plasma display panel in accordance with one embodiment of the present invention is capable of reducing the size of a plasma display device with the plasma display panel, due to no need of any additional base material in the formation of the EMI shielding filter.

While the present invention has been described in connection with certain exemplary embodiments, it is to be understood that the invention is not limited to the disclosed embodiments, but also is intended to cover various modifications and equivalent arrangements included within the scope of the appended claims.

## Claims

1. A method of manufacturing a plasma display panel (100), comprising the steps of:
preparing a first panel (110) of the plasma display panel (100) having a first surface and a second surface, the second surface being the display surface of the plasma display panel (100); and
forming an electromagnetic wave shield filter (150) on said second surface of the first panel (110) comprising the steps:
- forming a hydrophobic layer (130) by applying a coating solution to said second surface of the first panel (110) (step S2);
- forming a conductive mesh pattern (140) of individual ink drops (140') connected to one another forming conductive lines by ink-jet printing a conductive ink directly on the hydrophobic layer (130) (step S3); and
- heating the conductive ink and the coating solution to fix the conductive mesh pattern (140) on the hydrophobic layer (step S4).

2. The method of daim 1, wherein the coating solution is applied to the entirety of the second surface of the first panel (110), and/or wherein the coating solution is applied by printing or spin coating.

3. The method of claims 1 or 2, wherein the coating solution comprises fluoroalkylsilane (FAS) and/or wherein the coating solution comprises fluoroalkylsilane (FAS) in a concentration between 0.05M and 0.3M.

4. The method of daim 3, wherein fluoroalkylsilane is a mixture of trichloro(3,3,3-trifluoropropyl)silane and trichloro(1H,1H,2H,2H-perfluorooctyl)silane.

5. The method of daim 4, further comprising 3-aminopropyl triethoxy silane and/or 3-mercaptopropyl triethoxy silane.

6. The method of daim 4 or 5, wherein the ratio of volumes of the mixtures of tichloro(3,3,3-trifluoropropyl)silane and trichloro(1H,1H,2H,2H-perfluorooctyl)silane is between 100:1 to 20:1

7. The method of daim 1, wherein the individual ink drops (140') have a volume of 3pL to 30pL.

8. The method of any of the previous daims, wherein the conductive ink is a silver nano ink and/or the conductive ink indudes trace amounts of organic dispersant and inorganic frit.

9. The method of daim 8, wherein the silver nano ink is a dispersion of silver nano-particles having a particle diameter of 5nm to 100nm in n-tetradecane and/or a content of the silver nano-partilcldes is in the range of 50wt% to 90wt% in the conductive ink.

10. The method of any of the previous daims, wherein the heating step (S4) indudes heating the conductive mesh pattern (140) and the hydrophobic layer (130) to a temperature at which organic materials are removed from the conductive mesh pattern (140) and/or wherein the heating step (S4) indudes heating to temperatures between 250°C and 400°C.

11. The method of any of the previous daims, wherein the conductive mesh pattern (140):
has a line width of 30 to 70 µm; and/or
has a mesh surface resistance of 0.05 to 0.4 Ω/square; and/or
forms a tetragonal pattern of a plurality of the conductive lines with a pitch of between 200µm and 400µm; and/or
is formed of a plurality of the conductive lines ,formed by the individual connected ink drops, with a line width of repeated thick and thin portions with an average ratio of the thickest portion to the thinnest portion of each of the plurality of the conductive lines between 1.0:0.6 and 1.0:0.9.

12. The method of any of the previous daims, wherein the hydrophobic layer (130) is formed by applying a coating solution directly to said second surface of the first panel (110).

13. The method of any of the previous daims, wherein the conductive mesh pattern (140) is formed directly on an outside surface of the front glass of the plasma display panel (100) and/or wherein the conductive mesh pattern (140) is formed as the last step of the fabrication of the plasma display panel (100).

14. A plasma display panel (100) comprising:
a first panel (110) having a first surface and a second surface, the second surface being the display surface of the plasma display panel (100), and
an electromagnetic wave shield filter (150) provided on the second surface of said first panel (110),
the electromagnetic wave shield filter (150) comprises a hydrophobic layer (130) provided directly on the second surface and a conductive mesh pattern (140) provided directly on the hydrophobic layer, **characterized in that**, the conductive mesh pattern is formed of ink-jet printed individual ink drops (140') connected to one another forming conductive lines of the mesh pattern.

15. The plasma display panel (100) of claims 14, wherein the conductive mesh pattern (140):
has a line width of 30 to 70 µm; and/or
has a mesh surface resistance of 0.05 to 0.4 Ω/square; and/or
forms a tetragonal pattern of a plurality of conductive lines with a pitch of between 200µm and 400µm;
and/or
is formed of a plurality of the conductive lines ,formed by the individual connected ink drops, with a line width of repeated thick and thin portions with an average ratio of the thickest portion to the thinnest portion of each of the plurality of conductive lines between 1.0:0.6 and 1.0:0.9.

16. The plasma display panel (100) of claims 14 or 15, wherein the hydrophobic layer comprises fluoroalkylsilane.

17. The plasma display panel (100) of any of claims 14-16, wherein the conductive mesh pattern comprises or consists of silver nano particles.

## Patentansprüche

1. Verfahren zur Herstellung einer Plasmaanzeigetafel (100), das die folgenden Schritte umfasst :
Herstellung einer ersten Tafel (110) der Plasmaanzeigetafel (100) mit einer ersten Fläche und
einer zweiten Fläche, wobei die zweite Fläche die Anzeigefläche der Plasmaanzeigetafel (100) ist; und
Bildung eines Schutzfilters gegen elektromagnetische Wellen (150) auf der zweiten Fläche der ersten Tafel (110), die die folgenden Schritte umfasst:
- Bildung einer hydrophoben Schicht (130) durch Aufbringen einer Beschichtungslösung auf die zweite Fläche der ersten Tafel (110) (Schritt S2);
- Bildung eines leitfähigen Gittermusters (140) auf einzelnen, miteinander verbundenen Tintentropfen (140'), die Leiterbahnen bilden, indem leitfähige Tinte durch Tintenstrahldruck direkt auf die hydrophobe Schicht (130) gedruckt wird (Schritt S3); und
- Erwärmung der leitfähigen Tinte und der Beschichtungslösung, um das leitfähige Gittermuster (140) auf der hydrophoben Schicht zu fixieren (Schritt S4).

2. Verfahren nach Anspruch 1, wobei die Beschichtungslösung auf die gesamte zweite Fläche der ersten Tafel (110) aufgetragen wird, und/oder wobei die Beschichtungslösung durch Drucken oder Rotationsbeschichtung (*spin coating*) aufgebracht wird.

3. Verfahren nach Anspruch 1 oder 2, wobei die Beschichtungslösung Fluoralkylsilan (FAS) in einer Konzentration zwischen 0,05M und 0,3M aufweist.

4. Verfahren nach Anspruch 3, wobei Fluoralkylsilan eine Mischung aus Trichlor(3,3,3-Trifluorpropyl)silan und Trichlor(1H, 1H, 2H, 2H-Perfluoroctyl)silan ist.

5. Verfahren nach Anspruch 4, das weiterhin 3-Aminopropyltriethoxysilan und/oder 3-Mercaptopropyltriethoxysilan aufweist.

6. Verfahren nach Anspruch 4 oder 5, wobei das Volumenverhältnis der Mischungen aus Trichlor(3,3,3-Trifluorpropyl)silan und Trichlor(1H, 1H, 2H, 2H-Perfluoroctyl)silan zwischen 100:1 und 20:1 beträgt.

7. Verfahren nach Anspruch 1, wobei die einzelnen Tintentropfen (140') ein Volumen von 3 pL bis 30 pL besitzen.

8. Verfahren nach einem der vorhergehenden Ansprüche, wobei die leitfähige Tinte eine Silbernanotinte ist und/oder die leitfähige Tinte Spurenmengen eines organischen Dispergens und inorganischer Fritte besitzt.

9. Verfahren nach Anspruch 8, wobei die Silbernanotinte eine Dispersion von Silbernanopartikeln mit einem Partikeldurchmesser von 5 nm bis 100 nm in n-Tetradecan ist und/oder der Gehalt an Silbernanopartikeln in der leitfähigen Tinte in dem Bereich zwischen 50 Gewichtsprozent und 90 Gewichtsprozent liegt.

10. Verfahren nach einem der vorhergehenden Ansprüche, wobei der Schritt der Erwärmung (S4) das Erwärmen des leitfähigen Gittermusters (140) und der hydrophoben Schicht (130) auf eine Temperatur umfasst, bei der organische Materialien aus dem leitfähigen Gittermuster (140) entfernt werden, und/oder wobei der Schritt der Erwärmung (S4) ein Erwärmen auf Temperaturen zwischen 250 °C und 400 °C umfasst.

11. Verfahren nach einem der vorhergehenden Ansprüche, wobei das leitfähige Gittermuster (140):
eine Linienbreite von 30 bis 70 µm besitzt; und/oder
einen Oberflächenwiderstand des Gittermusters von 0,05 bis 0,4 Ω/Quadrat besitzt; und/oder ein tetragonales Muster einer Vielzahl der Leiterbahnen mit einem Abstand zwischen 200 µm und 400 µm bildet; und/oder
aus einer Vielzahl der Leiterbahnen gebildet ist, die aus den einzelnen, miteinander verbundenen Tintentropfen gebildet werden, mit einer Linienbreite wiederholter breiter und
schmaler Abschnitte mit einem durchschnittlichen Verhältnis des breitesten Abschnittes zu dem schmalsten Abschnitt jeder der Vielzahl der Leiterbahnen zwischen 1,0:0,6 und 1,0:0,9.

12. Verfahren nach einem der vorhergehenden Ansprüche, wobei die hydrophobe Schicht (130) durch direktes Aufbringen einer Beschichtungslösung auf die erste Tafel (110) gebildet ist.

13. Verfahren nach Anspruch nach einem der vorhergehenden Ansprüche, wobei das leitfähige Gittermuster (140) direkt an einer Außenfläche des Frontglases der Plasmaanzeigetafel (100) gebildet ist, und/oder wobei das leitfähige Gittermuster (140) als letzter Herstellungsschritt der Plasmaanzeigetafel (100) gebildet wird.

14. Plasmaanzeigetafel (100) mit:
einer ersten Tafel (110) mit einer ersten Fläche und einer zweiten Fläche, wobei die zweite Fläche die Anzeigefläche der Plasmaanzeigetafel (100) ist; und
einem Schutzfilter gegen elektromagnetische Wellen (150) an der zweiten Fläche der ersten Tafel (110),
der Schutzfilter gegen elektromagnetische Wellen (150) besitzt eine hydrophobe Schicht (130), die sich direkt auf der zweiten Fläche befindet, und ein leitfähiges Gittermuster (140), das sich direkt auf der hydrophoben Schicht (130) befindet, **dadurch gekennzeichnet, dass** das leitfähige Gittermuster aus mit Tintenstrahldruck gedruckten, einzelnen Tintentropfen (140') gebildet ist, die miteinander verbunden sind, und Leiterbahnen des Gittermusters bilden.

15. Plasmaanzeigetafel (100) nach Anspruch 14, wobei das leitfähige Gittermuster (140):
eine Bahnbreite von 30 bis 70 µm besitzt; und/oder
einen Oberflächenwiderstand des Gittermusters von 0,05 bis 0,4 Ω/Quadrat besitzt; und/oder ein tetragonales Muster einer Vielzahl von Leiterbahnen mit einem Abstand zwischen 200 µm und 400 µm bildet; und/oder
aus einer Vielzahl von Leiterbahnen gebildet ist, die aus den einzelnen, miteinander verbundenen Tintentropfen gebildet werden, mit einer Linienbreite wiederholter breiter und
schmaler Abschnitte mit einem durchschnittlichen Verhältnis des breitesten Abschnittes zu dem schmalsten Abschnitt jeder der Vielzahl von Leiterbahnen zwischen 1,0:0,6 und 1,0:0,9.

16. Plasmaanzeigetafel (100) nach Anspruch 14 oder 15, wobei die hydrophobe Schicht Fluoralkylsilan aufweist.

17. Plasmaanzeigetafel (100) nach einem der Ansprüche 14 bis 16, wobei das leitfähige Gittermuster Silbernanopartikel aufweist oder aus ihnen besteht.

## Revendications

1. Procédé pour la production d'un panneau d'affichage à plasma (100), comprenant les étapes consistant à :
préparer un premier panneau (110) du panneau d'affichage à plasma (100), ayant une première surface et une seconde surface, la seconde surface étant la surface d'affichage du panneau d'affichage à plasma (100) ; et
former un filtre de protection contre les ondes électromagnétiques (150) sur ladite seconde surface du premier panneau (110), comprenant les étapes consistant à :
- former une couche hydrophobe (130) en appliquant une solution de revêtement à ladite seconde surface du premier panneau (110) (étape S2) ;
- former un réseau conducteur (140) de gouttes d'encre individuelles (140') connectées les unes aux autres en formant des lignes conductrices par impression par jet d'encre en appliquant une encre conductrice directement sur la couche hydrophobe (130) (étape S3) ; et
- chauffer l'encre conductrice et la solution de revêtement pour fixer le réseau conducteur (140) sur la couche hydrophobe (étape S4).

2. Procédé suivant la revendication 1, dans lequel la solution de revêtement est appliquée à la totalité de la seconde surface du premier panneau (110), et/ou dans lequel la solution de revêtement est appliquée par impression ou revêtement centrifuge.

3. Procédé suivant la revendication 1 ou 2, dans lequel la solution de revêtement comprend un fluoralkylsilane (FAS) et/ou dans lequel la solution de revêtement comprend un fluoralkylsilane (FAS) à une concentration de 0,05 M à 0,3 M.

4. Procédé suivant la revendication 3, dans lequel le fluoralkylsilane est un mélange de trichloro(3,3,3-trifluoropropyl)silane et de trichloro (1H,1H,2H,2H-perfluorooctyl)silane.

5. Procédé suivant la revendication 4, comprenant en outre du 3-aminopropyl-triéthoxy-silane et/ou du 3-mercapto-propyltriéthoxy-silane.

6. Procédé suivant la revendication 4 ou 5, dans lequel le rapport des volumes des mélanges de trichloro-(3,3,3-trifluoropropyl)silane et de trichloro(1H,1H,2H,2H-perfluorooctyl)silane est compris entre 100:1 et 20:1.

7. Procédé suivant la revendication 1, dans lequel les gouttes d'encre individuelles (140') ont un volume de 3 pL à 30 pL.

8. Procédé suivant l'une quelconque des revendications précédentes, dans lequel l'encre conductrice est une nano-encre à l'argent et/ou l'encre conductrice comprend des traces d'un dispersant organique et d'un composé fritté inorganique.

9. Procédé suivant la revendication 8, dans lequel la nano-encre à l'argent est une dispersion de nanoparticules d'argent ayant un diamètre de particule de 5 nm à 100 nm dans du n-tétradécane et/ou la quantité des nanoparticules d'argent est comprise dans l'intervalle de 50 % en poids à 90 % en poids dans l'encre conductrice.

10. Procédé suivant l'une quelconque des revendications précédentes, dans lequel l'étape de chauffage (S4) comprend le chauffage du réseau conducteur (140) et de la couche hydrophobe (130) à une température à laquelle les matières organiques sont éliminées du réseau conducteur (140) et/ou dans lequel l'étape de chauffage (S4) comprend un chauffage à des températures comprises entre 250°C et 400°C.

11. Procédé suivant l'une quelconque des revendications précédentes, dans lequel le réseau conducteur (140) :
a une largeur de ligne de 30 à 70 µm ; et/ou
a une résistance de surface de réseau de 0,05 à 0,4 Ω/carré ; et/ou
forme un motif tétragonal d'une pluralité de lignes conductrices avec un pas entre 20 µm et 400 µm ; et/ou
est formé d'une pluralité de lignes conductrices, formées par les gouttes d'encre individuelles connectées, avec une largeur de ligne de portions épaisses et minces répétées ayant un rapport moyen de la portion la plus épaisse à la portion la plus mince de chacune de la pluralité de lignes conductrices entre 1,0:0,6 et 1,0:0,9.

12. Procédé suivant l'une quelconque des revendications précédentes, dans lequel la couche hydrophobe (130) est formée en appliquant une solution de revêtement directement à ladite seconde surface du premier panneau (110).

13. Procédé suivant l'une quelconque des revendications précédentes, dans lequel le réseau conducteur (140) est formé directement sur une surface extérieure de la vitre frontale du panneau d'affichage à plasma (100) et/ou dans lequel le réseau conducteur (140) est formé comme dernière étape de la fabrication du panneau d'affichage à plasma (100).

14. Panneau d'affichage à plasma (100), comprenant :
un premier panneau (110) ayant une première surface et une seconde surface, la seconde surface étant la surface d'affichage du panneau d'affichage à plasma (100), et
un filtre de protection contre les ondes électromagnétiques (150) présent sur la seconde surface dudit premier panneau (110),
le filtre de protection contre les ondes électromagnétiques (150) comprenant une couche hydrophobe (130) présente directement sur la seconde surface et un réseau conducteur (140) présent directement sur la couche hydrophobe, **caractérisé en ce que** le réseau conducteur est formé de gouttes d'encre individuelles imprimées par jet d'encre (140') connectées les unes aux autres en formant les lignes conductrices du réseau.

15. Panneau d'affichage à plasma (100) suivant la revendication 14, dans lequel le réseau conducteur (140) :
a une largeur de ligne de 30 à 70 µm ; et/ou
a une résistance de surface de réseau de 0,05 à 0,4 Ω/carré ; et/ou
forme un motif tétragonal d'une pluralité de lignes conductrices avec un pas entre 20 µm et 400 µm ; et/ou
est formé d'une pluralité de lignes conductrices, formées par les gouttes d'encre individuelles connectées, avec une largeur de ligne de portions épaisses et minces répétées ayant un rapport moyen de la portion la plus épaisse à la portion la plus mince de chacune de la pluralité de lignes conductrices entre 1,0:0,6 et 1,0:0,9.

16. Panneau d'affichage à plasma (100) suivant la revendication 14 ou 15, dans lequel la couche hydrophobe comprend un fluoralkylsilane.

17. Panneau d'affichage à plasma (100) suivant l'une quelconque des revendications 14 à 16, dans lequel le réseau conducteur comprend ou consiste en des nanoparticules d'argent.
